Europäisches Patentamt

European Patent Office

Office européen des brevets

(11) Veröffentlichungsnummer: **0 344 479**

**A1**

(12) # EUROPÄISCHE PATENTANMELDUNG

(21) Anmeldenummer: 89107989.9

(51) Int. Cl.⁴: **G01R 35/00 , G01R 19/145**

(22) Anmeldetag: 03.05.89

(30) Priorität: 28.05.88 DE 3818259

(43) Veröffentlichungstag der Anmeldung:
06.12.89 Patentblatt 89/49

(84) Benannte Vertragsstaaten:
AT BE CH ES FR GB GR IT LI LU NL SE

(71) Anmelder: KARL PFISTERER
ELEKTROTECHNISCHE SPEZIALARTIKEL
GMBH & CO. KG
Inselstrasse 140
D-7000 Stuttgart 60(DE)

(72) Erfinder: Schächterle, Werner
Posttor 25
D-7057 Winnenden(DE)
Erfinder: Sander, Dieter, Dipl.-Ing.
Malachitweg 12
D-7000 Stuttgart 75(DE)
Erfinder: Schuster, Martin, Dipl.-Ing.
Heidestrasse 51
D-7300 Esslingen(DE)

(74) Vertreter: Patentanwälte Phys. Bartels
Dipl.-Ing. Fink Dr.-Ing. Held
Lange Strasse 51
D-7000 Stuttgart 1(DE)

(54) **Vorrichtung zur optischen Anzeige des Betriebszustandes eines wegen einer Isolation oder Kapselung unzugänglichen Leiters eines Energieversorgungsnetzes.**

(57) Eine Vorrichtung zur optischen Anzeige des Betriebszustandes eines wegen einer Isolation oder Kapselung unzugänglichen Leiters eines Energieversorgungsnetzes, die über eine Steckverbindung, bestehend aus einem an der Vorrichtung vorgesehenen Steckerteil (8) mit zwei Kontaktelementen (9') und einem mit dem zu prüfenden Leiter des Energieversorgungsnetzes kapazitiv oder induktiv in Verbindung stehenden Steckerteil, mit dem an letzterem angeschlossenen Spannungssensor und/oder Stromsensor verbindbar ist, weist eine elektronische Schaltung (3) auf, welche wenigstens ein optisches Anzeigeelement (5, 6) mit einer für eine Anzeige ausreichenden Spannung versorgt, sofern an den Kontaktelementen (9') ein Signal ausreichender Größe anliegt. Die elektronische Schaltung (3) ist durch eine Batterie (4) ergänzt. Die Kontaktelemente (9') sind als feste Kontaktstücke eines mittels einer niederohmigen Kontaktbrücke (11) schließbaren Schalters vorgesehen, der bei einem Schließvorgang die Energieversorgung der elektronischen Schaltung (3) von der Batterie (4) her einschaltet und gleichzeitig eine Eigenprüfung der gesamten elektronischen Schaltung (3) einschließlich der Kontaktelemente (9, 9') und des optischen Anzeigeelementes (5, 6) auslöst.

Fig.3

# Vorrichtung zur optischen Anzeige des Betriebszustandes eines wegen einer Isolation oder Kapselung unzugänglichen Leiters eines Energieversorgungsnetzes

Die Erfindung betrifft eine Vorrichtung zur optischen Anzeige des Betriebszustandes eines wegen einer Isolation oder Kapselung unzugänglichen Leiters eines Energieversorgungsnetzes, insbesondere eines Mittelspannungsenergieversorgungsnetzes, gemäß dem Oberbegriff des Anspruches 1.

Es ist bekannt (US-PS 34 25 049), bei einer Durchführung für ein elektrisches Kabel, die mit einer auf Erdpotential liegenden metallischen Ummantelung versehen ist und auf dieser eine Spannungsanzeigevorrichtung trägt, welche an eine isolierend in die Durchführung eingebettete Elektrode angeschlossen ist, eine elektrisch leitende Verbindung zu einem Kontaktelement vorzusehen, das in der Außenmantelfläche der Durchführung gegenüber deren Ummantelung elektrisch isoliert angeordnet ist. Zur Prüfung der Funktionsfähigkeit der Spannungsanzeige wird an dieses Kontaktelement und die Ummantelung eine Prüfspannung angelegt. Nachteilig ist hierbei vor allem, daß durch eine unbeabsichtigte, leitende Überbrückung der Isolation zwischen dem Kontaktelement und der Ummantelung die Spannungsanzeige vorrichtung funktionsunfähig gemacht wird und dadurch eine Spannungslosigkeit des Kabels vortäuscht, obwohl dieses unter Spannung steht.

Zuverlässiger ist deshalb eine bekannte Vorrichtung der eingangs genannten Art (DE-PS 32 14 484), die mit einem in eine übliche Steckdose eines Niederspannungs-Energieversorgungsnetzes einsetzbaren Stecker versehen ist, der nicht nur zur Herstellung einer Steckverbindung mit der die zu überwachende Spannung liefernden Spannungsquelle dient, sondern zum Zwecke der Funktionsprüfung der Vorrichtung das Einstecken in eine übliche Steckdose ermöglicht, welche die für die Funktionsprüfung erforderliche Spannung liefert.

Der Erfindung liegt die Aufgabe zugrunde, eine Vorrichtung der eingangs genannten Art zu schaffen, deren Funktionsfähigkeit auch dann problemlos geprüft werden kann, wenn keine Steckdose eines Niederspannungs-Energieversorgungsnetzes zur Verfügung steht. Diese Aufgabe löst eine Vorrichtung mit den Merkmalen des Anspruches 1.

Mit Hilfe der von der Batterie gelieferten Energie kann unabhängig von einer fremden Energiequelle jederzeit eine sogenannte Eigenprüfung durchgeführt werden, d.h. die Funktionsfähigkeit der Vorrichtung überprüft werden. Von Vorteil ist hierbei, daß in diese Eigenprüfung auch die Kontaktelemente einbezogen werden, da über sie der Einschaltstrom fließen muß. Von besonderem Vorteil ist jedoch, daß es nicht in das Belieben der Bedienungsperson gestellt ist, ob eine Funktionsprüfung durchgeführt wird oder nicht, weil die für eine Inbetriebnahme erforderliche Einschaltung der Vorrichtung nur zusammen mit einer Funktionsprüfung möglich ist.

Um sicher zu stellen, daß die Eigenprüfung wiederholt werden muß, wenn die Steckverbindung getrennt worden ist, kann man die elektronische Schaltung so ausbilden, daß die Vorrichtung beim Trennen der Steckverbindung selbsttätig, gegebenenfalls nach einer vorgegebenen Zeit, abgeschaltet wird.

Als Kontaktbrücke kann jedes beliebige, blanke Metallstück verwendet werden, das ausreichend niederohmig ist, also beispielsweise der Schaft eines Schraubendrehers. Um ein unbeabsichtigtes Einschalten der Vorrichtung zu vermeiden, ist es jedoch vorteilhaft, wenn die Kontaktabrücke Bestandteil einer Abdeckkappe für die Kontaktelemente ist.

Damit die Vorrichtung in die in vielen Fällen bereits vorhandenen Steckbuchsen eingesteckt werden kann, sind vorzugsweise die Kontaktelemente durch zwei Kontaktstifte gemäß Anspruch 3 gebildet, die zweckmäßigerweise gemäß Anspruch 4 wie die Kontaktstifte eines Europasteckers ausgebildet sind.

Die Abdeckkappe, die vorzugsweise unverlierbar mit der Vorrichtung verbunden ist, kann beispielsweise aus Metall bestehen, so daß nur die Abdeckkappe selbst an die beiden Kontaktstifte angelegt zu werden braucht, um die Vorrichtung einzuschalten und die Eigenprüfung zu bewirken. Damit die Einschaltung nicht unbeabsichtigt erfolgen kann, kann man die Abdeckkappe mit einem Isolierkörper versehen, welcher bei aufgesetzter Kappe an den Kontaktstiften anliegt. Man kann aber auch eine Abdeckkappe aus einem elektrisch isolierenden Material vorsehen und dann beispielsweise in den Boden der Abdeckkappe nach außen freiliegend die metallische Brücke einbetten. Die Kappe braucht dann nur abgenommen und mit ihrer Rückseite an die Steckerstifte angelegt zu werden, um die Vorrichtung einzuschalten und ihre Funktionsfähigkeit zu prüfen.

Im folgenden ist die Erfindung an Hand eines in der Zeichnung dargestellten Ausführungsbeispiels im einzelnen erläutert.
Es zeigen

Fig. 1 eine Seitenansicht des Ausführungsbeispiels,
siehe Eingabe vom 25.08.1988

Fig. 2 eine teilweise aufgebrochen dargestellte Seitenansicht des Ausführungsbeispiels in einer um 90° gegenüber der Ansicht gemäß Fig. 1 gedrehten Lage,

Fig. 3 eine schematische Darstellung des Ausführungsbeispiels mit seinem Schaltschema.

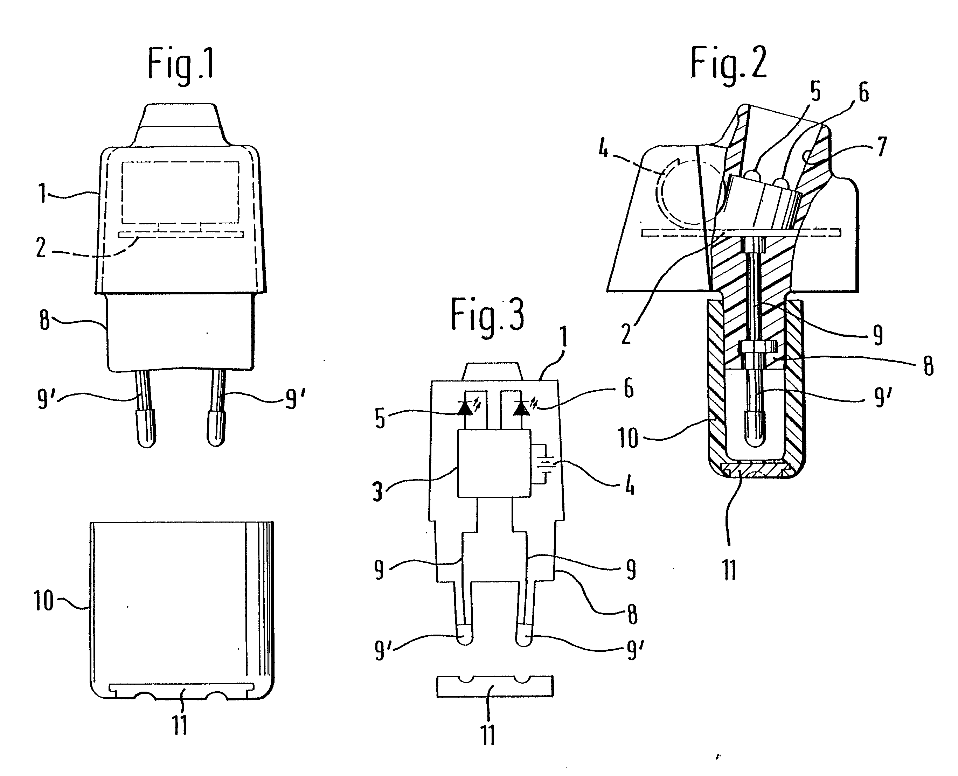

Eine Vorrichtung zur optischen Anzeige des Zustandes eines Leiters eines Enerversorgungsnetzes enthält in einem elektrisch isolierenden Gehäuse 1 eine Leiterplatte 2, die eine elektronische Schaltung 3 trägt, welche an eine ebenfalls im Gehäuse 1 angeordnete Batterie 4 angeschlossen ist. Ferner trägt die Leiterplatte 2, wie Fig. 2 zeigt, eine Fassung für zwei Leuchtdioden 5 und 6, von denen die erste rotes und die zweite grünes Licht auszusenden vermag. Die Leuchtdioden 5 und 6 liegen am Grund eines vom Gehäuse 1 gebildeten, nach außen offenen Schachtes 7, welcher als Sichtblende dient, um zuverlässig erkennen zu können, ob und gegebenenfalls welche der beiden Leuchtdioden 5 und 6 leuchtet.

Auf der dem Schacht 7 abgewandten Seite ist das Gehäuse 1 mit einem von ihm abstehenden, blockförmigen Ansatz 8 versehen dessen Abmessungen den Abmessungen des Isolierteiles eines Europasteckers entsprechen. In den Ansatz 8 sind zwei Kontaktstifte 9 eingebettet, welche elektrisch leitend an die elektronische Schaltung 3 angeschlossen sind. Die Kontaktstifte 9 stehen über die freie Stirnfläche des Ansatzes 8 über. Ihr überstehender Abschnitt 9′ ist wie ein Steckerstift eines Europasteckers ausgebildet. Außerdem ist der Abstand zwischen den beiden überstehenden Abschnitten 9′ an den Abstand der Steckerstifte eines Europasteckers angepaßt. Der aus den Abschnitten 9′ und dem Ansatz 8 gebildete Stecker, bei dem es sich im Ausführungsbeispiel um einen Europastecker handelt, kann deshalb in die für einen Europastecker geeigneten Steckbuchsen eingesteckt werden. Mit einer solchen Steckbuchse ist auch die Spannungsquelle ausgerüstet, welche eine der Spannung des zu überwachenden Leiters entsprechende, jedoch niedrigere Spannung liefert.

Auf den von den Abschnitten 9′ und dem Ansatz 8 gebildeten Europastecker ist eine aus elektrisch isolierendem Kunststoff bestehende Abdeckkappe 10 aufsteckbar, in deren Boden zur Außenseite hin freiliegend eine niederohmige Kontaktbrücke 11 eingebettet ist. Zum Inneren der Abdeckkappe 10 hin ist die Kontaktbrücke 11 von dem elektrisch isolierenden Material der Abdeckkappe 10 vollständig bedeckt.

Um die Vorrichtung einzuschalten, wird die Abdeckkappe 10 abgezogen und die Kontaktbrücke 11 in Anlage an die Enden der beiden Abschnitte 9′ der Kontaktstifte 9 gebracht. Da der Eingang der elektronischen Schaltung über die beiden Kontakt

stifte 9 sehr hochohmig ist, braucht an die Kontaktqualität zwischen der Kontaktbrücke 11 und den Kontaktstiften 9 keine hohen Ansprüche gestellt zu werden. Das Kurzschließen der beiden Kontaktstifte 9 mittels der Kontaktbrücke 11 bewirkt zum einen, daß die Energieversorgung der elektronischen Schaltung 3 durch die Batterie 4 mittels eines nicht dargestellten elektronischen Schalters eingeschaltet wird. Gleichzeitig wird durch das Kurzschließen der Kontaktstifte 9 aber auch eine sogenannte Eigenprüfung der Vorrichtung ausgelöst, d.h. eine Prüfung ihrer Funktionsfähigkeit, wobei in diese Eigenprüfung die beiden Kontaktstifte 9 einbezogen sind. Sofern die Vorrichtung funktionsfähig ist, leuchtet zunächst die grüne Leuchtdiode 5 auf. Danach leuchtet für eine vorgegebene Zeit von beispielsweise 5 sec. die rote Leuchtdiode auf. Ist die Vorrichtung voll funktionsfähig, erlischt die rote Leuchtdiode 6 nach kurzer Zeit wieder und die grüne Leuchtdiode leuchtet erneut auf. Danach wird der Kontakt zwischen der Kontaktbrücke 11 und den Kontaktstiften 9 unterbrochen.

Nach dieser Funktionsprüfung kann der durch die Abschnitte 9′ und den Ansatz 8 gebildete Stekker in die für seine Aufnahme vorgesehene Steckbuchse eingesteckt werden. Man hat dann eine ständige Anzeige darüber, ob das zugeordnete Kabel unter Spannung steht oder spannungsfrei ist.

Alle in der vorstehenden Beschreibung erwähnten sowie auch die nur allein aus der Zeichnung entnehmbaren Merkmale sind als weitere Ausgestaltungen Bestandteile der Erfindung, auch wenn sie nicht besonders hervorgehoben und insbesondere nicht in den Ansprüchen erwähnt sind.

**Ansprüche**

1. Vorrichtung zur optischen Anzeige des Betriebszustandes eines wegen einer Isolation oder Kapselung unzugänglichen Leiters eines Energieversorgungsnetzes, die über eine Steckverbindung, bestehend aus einem an der Vorrichtung vorgesehenen Steckerteil mit zwei Kontaktelementen und einem mit dem zu prüfenden Leiter des Energieversorgungsnetzes kapazitiv oder induktiv in Verbindung stehenden Steckerteil angeschlossenen Spannungssensor und/oder Stromsensor verbindbar ist und eine elektronische Schaltung aufweist, welche wenigstens ein optisches Anzeigeelement mit einer für eine Anzeige ausreichenden Spannung versorgt, sofern an den Kontaktelement ein Signal ausreichender Größe anliegt, dadurch gekennzeichnet, daß die elektronische Schaltung (3) durch eine Batterie (4) ergänzt ist und daß die Kontaktelemente (9, 9′) als feste Kontaktstücke eines mittels einer niederohmigen Kontaktbrücke (11) schließbaren Schalters vorgesehen sind, der bei einem Schließvorgang die Energieversorgung der elektronischen Schaltung (3) von der Batterie (4) her einschaltet und gleichzeitig eine Eigenprüfung der gesamten elektronischen Schaltung (3) einschließlich der Kontaktelemente (9, 9') und des optischen Anzeigelementes (5, 6) auslöst.

2. Vorrichtung nach Anspruch 1, dadurch gekennzeichnet, daß die Kontaktbrücke (11) Bestandteil einer Abdeckkappe (10) für die Kontaktstücke (9') ist.

3. Vorrichtung nach Anspruch 1 oder 2, dadurch gekennzeichnet, daß die Kontaktstücke durch zwei von einem die elektronische Schaltung (3), die Batterie (4) und das optische Anzeigeelement (5, 6) enthaltenden Gehäuse (1) abstehende Kontaktstifte (9') gebildet sind.

4. Vorrichtung nach Anspruch 3, dadurch gekennzeichnet, daß die Kontaktstifte (9') und der sie tragende Teil (8) des Gehäuses (1) als Europastekker ausgebildet sind.

5. Vorrichtung nach einem der Ansprüche 2 bis 4, dadurch gekennzeichnet, daß die als Brücke an die Kontaktstücke anlegbare Abdeckkappe aus Metall besteht und einen im aufgesetzten Zustand der Abdeckkappe an den Kontaktstücken anliegenden Isolierkörper enthält.

6. Vorrichtung nach einem der Ansprüche 2 bis 4, dadurch gekennzeichnet, daß die Abdeckkappe (10) aus einem elektrisch isolierenden Material besteht und in sie die Kontaktbrücke (11) freiliegend eingebettet ist.

Fig.1

1

2

8

9' 9'

10

11

Fa. KARL PFISTERER....

Reg.Nr. 127 187

Fig.2

5 6

4 7

2

9

8

9'

10

11

Fig.3

1

5 6

3 4

9 9

8

9' 9'

11

EP 0 344 479 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | EP-A-0 092 151 (KARL PFISTERER ELEKTROTECHNISCHE SPEZIALARTIKEL GmbH) * Insgesamt * --- | 1,3,4 | G 01 R 35/00 G 01 R 19/145 |
| A | FR-A-2 603 113 (CATU) * Seite 2, Zeilen 1-10; Seite 3, Zeile 13 - Seite 4, Zeile 19; Figur 2 * --- | 1 | |
| A | EP-A-0 121 507 (K. JONSSON) * Seite 3, Zeile 33 - Seite 4, Zeile 30; Figur 1 * ----- | 1 | |

|  |  |
|---|---|
| | RECHERCHIERTE SACHGEBIETE (Int. Cl.4) |
| | G 01 R 1/00 G 01 R 19/00 G 01 R 31/00 G 01 R 35/00 H 01 R 31/00 |

Der vorliegende Recherchenbericht wurde für alle Patentansprüche erstellt

| Recherchenort | Abschlußdatum der Recherche | Prüfer |
|---|---|---|
| DEN HAAG | 15-09-1989 | TRELEVEN C. |